# EUROPEAN PATENT APPLICATION

(11) **EP 4 782 927 A1**
(43) Date of publication of application: **29.07.2026**
(21) Application number: 26152141.3
(22) Date of filing: 15.01.2026
(51) Int. Cl.: G03G 15/00, G03G 21/16, H01H 13/00, H05K 1/02, H05K 9/00, H01H 13/52

(54) **IMAGE FORMING APPARATUS**

(30) Priority: 27.01.2025 JP 2025011384
(71) Applicant: KYOCERA Document Solutions Inc., Osaka-shi, Osaka 540-8585 (JP)
(72) Inventor: Nohara, Yuta, Osaka-shi, 540-8585 (JP); Shinba, Minoru, Osaka-shi, 540-8585 (JP)
(74) Representative: Plougmann Vingtoft a/s

(57) **Abstract**

A switch unit is supported by a main body including a metallic structural body and includes a pressed part. A press button is supported to be movable by a cover member that closes the main body or an opening of the main body and moves from a reference position away from the pressed part to a pressure position to press the pressed part by being pressed. An electrically conductive, electrostatic conduction member is supported by the main body and includes a contact part that comes into contact with a portion of the structural body and a button proximity part that is arranged at a position closer to the press button located at the reference position than the switch unit.

## Description

### Incorporation by Reference

This application is based upon and claims the benefit of priority from the corresponding Japanese Patent Application No. 2025-011384 filed on January 27, 2025.

### Background

The present disclosure relates to an image forming apparatus including a switch unit that is pressed to switch an electrified state.

For example, an image forming apparatus includes a press button switch, such as a power switch.

### Summary

An image forming apparatus according to an aspect of the present disclosure is an apparatus that forms an image on a sheet. The image forming apparatus includes a main body, a switch unit, a press button, and an electrostatic conduction member. The main body has a metallic structural body. The switch unit is supported by the main body, includes a pressed part, and has an electrified state which switches between a state in which the pressed part is pressed and a state in which the pressed part is not pressed. The press button is supported to be movable by a cover member that closes the main body or an opening of the main body and moves from a reference position away from the pressed part to a pressure position to press the pressed part by being pressed. The electrically conductive, electrostatic conduction member is supported by the main body and includes a contact part that comes into contact with a part of the structural body and a button proximity part that is arranged at a position closer to the press button located at the reference position than the switch unit.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. In addition, the claimed subject matter is not limited to implementations that solve any or all disadvantages noted in any part of this disclosure.

These and other objects, features and advantages of the present disclosure will become more apparent in light of the following detailed description of best mode embodiments thereof, as illustrated in the accompanying drawings.

### Brief Description of Figures

Fig. 1 is a configuration diagram of an image forming apparatus according to an embodiment.
Fig. 2 is a cross-sectional view of a power switch device in the image forming apparatus according to the embodiment.
Fig. 3 is a front view of a portion of an interior panel in the image forming apparatus according to the embodiment.
Fig. 4 is a perspective view of a switch unit in the power switch device of the image forming apparatus according to the embodiment.

### Detailed Description

Hereinafter, an embodiment of the present disclosure will be described with reference to the accompanying drawings. The following embodiment is an example embodying the present disclosure and is not intended to limit the technical scope of the present disclosure.

### [Configuration of image forming apparatus 10]

An image forming apparatus 10 according to the embodiment is an apparatus that forms an image on a sheet 9. For example, the image forming apparatus 10 is a printer, a copying machine, a facsimile device, or a multifunction peripheral.

For example, the image forming apparatus 10 includes sheet storage parts 2, a sheet conveyance path 300, a sheet conveying device 3, a print device 4, and a toner supply device 5.

The sheet conveying device 3 includes a sheet feed device 30 and a plurality of conveying roller pairs 31. The sheet feed device 30 feeds each of sheets 9 stored in the sheet storage parts 2 to the sheet conveyance path 300. The plurality of conveying roller pairs 31 rotates, such that the sheet 9 is conveyed along the sheet conveyance path 300 and then output to an output tray 1x from the sheet conveyance path 300.

The print device 4 forms an image on the sheet 9 conveyed along the sheet conveyance path 300.

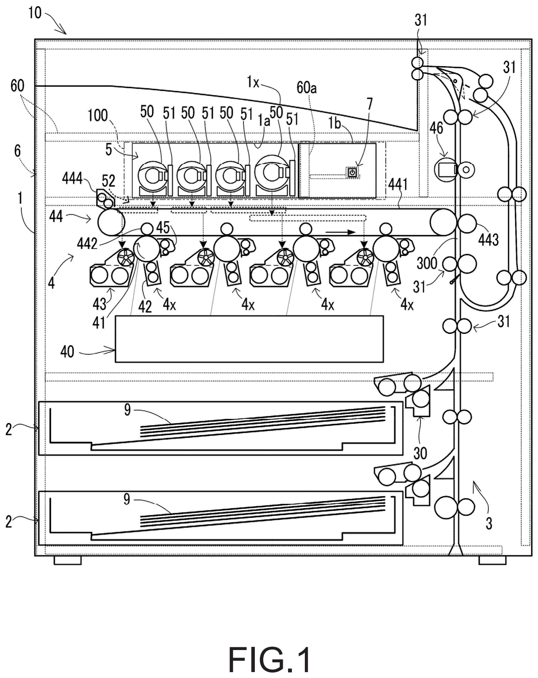

In the example shown in Fig. 1, the print device 4 forms an image on the sheet 9 by an electrophotographic method. In this case, the print device 4 includes one or more image forming parts 4x, a light scanning device 40, a transfer device 44, and a fuser device 46.

In the example shown in Fig. 1, the print device 4 includes a plurality of image forming parts 4x corresponding to a plurality of developing colors. For example, the plurality of developing colors is cyan, yellow, magenta, and black.

In each image forming part 4x, a drum-shaped photoreceptor 41 rotates and the charging device 42 charges a surface of the photoreceptor 41. The light scanning device 40 forms an electrostatic latent image on the surface of the photoreceptor 41 by scanning the surface of the photoreceptor 41 with a light beam.

In each image forming part 4x, a developing device 43 supplies the surface of the photoreceptor 41 with toner, thereby developing the electrostatic latent image to the toner image. The toner is an example of a developing agent.

The transfer device 44 transfers the toner image to the sheet 9 from the surface of the photoreceptor 41. In the example shown in Fig. 1, the transfer device 44 includes an intermediate transfer belt 441, a plurality of first transfer devices 442 corresponding to the plurality of image forming parts 4x, and a second transfer device 443 that is arranged along the sheet conveyance path 300.

Each of the first transfer devices 442 transfers the toner image to the intermediate transfer belt 441 from the surface of the photoreceptor 41 of each image forming part 4x. The second transfer device 443 transfers the toner image to the sheet 9 from the intermediate transfer belt 441.

In each image forming part 4x, a drum cleaning device 45 removes waste toner remaining on the surface of the photoreceptor 41. The transfer device 44 further includes a belt cleaning device 444 that removes waste toner remaining on the surface of the intermediate transfer belt 441.

The toner supply device 5 supplies toner to the developing devices 43 of the plurality of image forming parts 4x. The toner supply device 5 includes a plurality of toner containers 50, a plurality of container mounting parts 51, and a toner supply mechanism 52.

The plurality of toner containers 50 stores toner in different developing colors, respectively. Each toner container 50 is an example of a developing agent unit that stores the developing agent.

The plurality of container mounting parts 51 corresponds to the plurality of image forming parts 4x. Each container mounting part 51 is a part on which each toner container 50 is detachably mounted.

The toner supply mechanism 52 supplies toner to the developing device 43 of each image forming part 4x from each toner container 50 mounted on each container mounting part 51.

The sheet conveying device 3, the print device 4, and the toner supply device 5 are arranged inside a main body 1. The main body 1 includes a metallic structural body 6. The structural body 6 includes a plurality of metallic pipe members 60 joined by welding. In the present embodiment, each pipe member 60 is a rectangular pipe member.

The image forming apparatus 10 includes the main body 1 and a cover member 100. The cover member 100 closes a first opening 1a formed in the main body 1. The first opening 1a is an opening to the plurality of container mounting parts 51. The cover member 100 is supported to be capable of opening and closing the first opening 1a.

In a state in which the cover member 100 is opened, each toner container 50 can be replaced.

The image forming apparatus 10 further includes a power switch device 7 that switches the supply and cutoff of electric power for a plurality of electrical devices in the image forming apparatus 10. The electrified state of the power switch device 7 is switched by an operator pressing the power switch device 7.

In the present embodiment, the power switch device 7 is arranged in a region aligned with a region where the first opening 1a is formed in the main body 1.

By the way, when the operator touches the power switch device 7 with his or her static-charged finger, the static electricity may damage an electrical circuit of the power switch device 7.

The image forming apparatus 10 has a configuration to prevent the static electricity of the operator from being transmitted to the electrical circuit of the power switch device 7. Hereinafter, the configuration will be described.

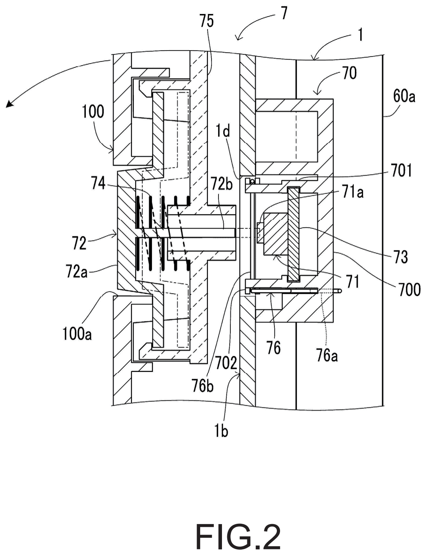

The power switch device 7 includes a switch unit 71 and a press button 72 (see Fig. 2). The switch unit 71 is supported by the main body 1. The press button 72 is supported by the cover member 100.

The switch unit 71 includes a pressed part 71a. The electrified state of the switch unit 71 switches between a state in which the pressed part 71a is pressed and a state in which the pressed part 71a is not pressed. The cover member 100 supports the press button 72 to be movable. The press button 72 moves from a reference position to a pressure position by the operator pressing the press button 72.

The reference position is a position away from the pressed part 71a. The pressure position is a position to press the pressed part 71a. In Fig. 2, the press button 72 located at the reference position is shown by the solid line and the press button 72 located at the pressure position is shown by the long dashed double-short dashed line.

The main body 1 includes an interior panel 1b having a second opening 1d to the pressed part 71a. The interior panel 1b covers a portion of the switch unit 71 other than the pressed part 71a. The interior panel 1b is an example of an interior member.

The cover member 100 covers a specific region in the main body 1, which includes the first opening 1a and the interior panel 1b (see Fig. 1). The cover member 100 is supported to be movable between a close position to cover the specific region of the main body 1 and an open position to open the specific region. In the present embodiment, the specific region is a region of a portion of the front surface of the image forming apparatus 10.

The press button 72 includes an operation part 72a that is pressed by the operator and a protruding part 72b that protrudes toward the pressed part 71a. The operation part 72a is exposed to the outside of the cover member 100 through a third opening 100a formed in the cover member 100.

The power switch device 7 further includes a spring 74 and a button holder 75. The button holder 75 holds the press button 72 and the spring 74 in the cover member 100.

The button holder 75 is supported by the cover member 100 and supports the press button 72 to be movable. That is, the press button 72 is supported by the cover member 100 via the button holder 75. The spring 74 biases the press button 72 toward the reference position. The spring 74 is an example of an elastic member.

The press button 72 moves from the reference position to the pressure position by being pressed against a biasing force of the spring 74. When the press on the press button 72 is cancelled, the biasing force of the spring 74 moves the press button 72 from the pressure position to the reference position.

The power switch device 7 further includes an electrically conductive electrostatic conduction member 76 supported by the main body 1 (see Figs. 2 to 4). The electrostatic conduction member 76 includes a contact part 76a and a button proximity part 76b (see Figs. 2 to 4). The contact part 76a comes into contact with a portion of the structural body 6. The button proximity part 76b is arranged in proximity to the protruding part 72b of the press button 72.

The button proximity part 76b is arranged at a position closer to the press button 72 located at the reference position than the switch unit 71 (see Fig. 2). That is, a distance between the press button 72 located at the reference position and the button proximity part 76b and a distance between the press button 72 located at the reference position and the switch unit 71.

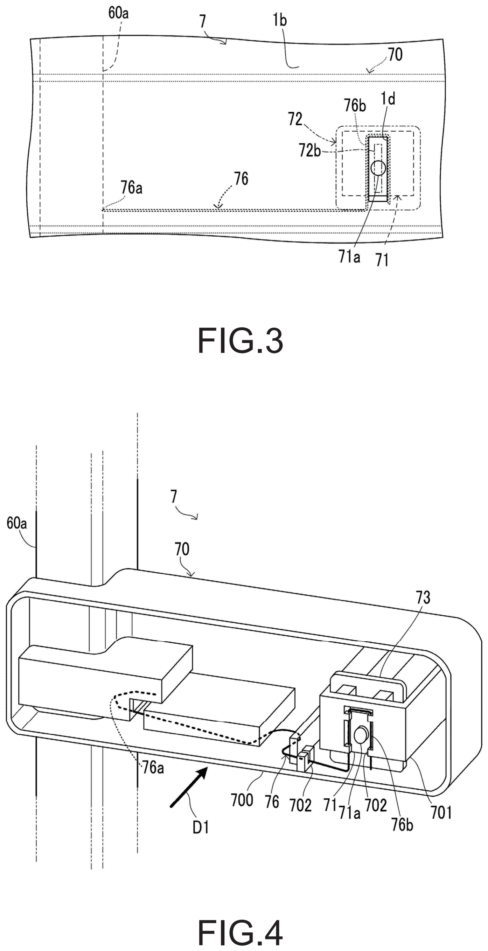

Specifically, the button proximity part 76b is arranged at an edge of the second opening 1d in the interior panel 1b (see Figs. 2 and 3). Fig. 3 is a front view of a portion of the interior panel 1b in the image forming apparatus, from which the cover member 100 is removed.

In the example shown in Fig. 3, the button proximity part 76b is arranged along three sides of four sides of the edge of the rectangular second opening 1d. More specifically, the button proximity part 76b is arranged along two long sides and one short side of the four sides of the edge of the rectangular second opening 1d.

When a static-charged operator touches the press button 72 in the power switch device 7, the static electricity flows from the press button 72 to the structural body 6 through the electrostatic conduction member 76. Accordingly, the static electricity is prevented from flowing to the electrical circuit of the switch unit 71.

In the present embodiment, the switch unit 71 is mounted on a switch board 73 (see Figs. 2 and 3). The power switch device 7 includes an electrical unit 70 including the switch unit 71, the switch board 73, and the electrostatic conduction member 76 (see Figs. 2 and 4). Fig. 4 is a perspective view of the electrical unit 70.

The electrical unit 70 is attached to the main body 1 at a position along an inner surface of the interior panel 1b (see Fig. 2).

The electrical unit 70 includes a switch holder 700 (see Figs. 2 and 4). The switch holder 700 supports the switch board 73 and the electrostatic conduction member 76. The switch holder 700 includes a first holding part 701 and a second holding part 702 (see Figs. 2 and 4). The first holding part 701 holds the switch board 73. The second holding part 702 holds the electrostatic conduction member 76.

The switch unit 71 is supported by the switch holder 700 via the switch board 73. Moreover, the switch unit 71 is supported by the main body 1 via the switch board 73 and the switch holder 700. The electrostatic conduction member 76 is supported by the main body 1 via the switch holder 700.

In the present embodiment, the electrostatic conduction member 76 is an elastically deformable, metallic wire (see Figs. 3 and 4).

The contact part 76a comes into contact with a surface of a specific pipe member 60a, which is one of the plurality of pipe members 60 (see Figs. 3 and 4). The contact part 76a is a bent part that hits a surface of the specific pipe member 60a (see Fig. 4).

Each of the plurality of pipe members 60 in the structural body 6 includes an electrically conductive, tubular base portion and a plating portion formed on a surface of the base portion. The plating portion is lower in electrical conductivity than the base portion. For example, the base portion is iron and the plating portion is zinc plating.

Therefore, in the power switch device 7, it is desirable that the contact part 76a come into contact with the base portion of the specific pipe member 60a.

The electrical unit 70 is inserted at an attachment position in the main body 1 in a predetermined insertion direction D1 (see Fig. 4). When the electrical unit 70 is inserted at the attachment position in the insertion direction D1, the contact part 76a, which is the bent part, slides on the surface of the specific pipe member 60a while the electrostatic conduction member 76 is elastically deformed.

For example, when the electrical unit 70 is attached to the main body 1, the electrical unit 70 is reciprocated in the insertion direction D1 once or multiple times before the electrical unit 70 is attached to the main body 1. Accordingly, the bent contact part 76a scraps the plating portion of the specific pipe member 60a, and a state in contact with the base portion easily occurs.

### [Modified examples]

The print device 4 may be a device that forms an image on the sheet 9 by a method other than the above-mentioned electrophotographic method, for example, an inkjet method. In a case where the print device 4 is an inkjet print device, a plurality of ink tanks that stores ink in different colors replaces the plurality of toner containers 50.

Similarly, in a case where the print device 4 is the above-mentioned inkjet print device, an ink supply mechanism replaces the toner supply mechanism 52. The ink supply mechanism supplies ink to the inkjet print device from each of the plurality of ink tanks.

Moreover, the button holder 75 may be supported by the main body. That is, the press button 72 may be supported by the main body 1 via the button holder 75.

It is to be understood that the embodiments herein are illustrative and not restrictive, since the scope of the disclosure is defined by the appended claims.

It should be understood by those skilled in the art that various modifications, combinations, sub-combinations and alterations may occur depending on design requirements and other factors insofar as they are within the scope of the appended claims or the equivalents thereof.

## Claims

1. An image forming apparatus (10) that forms an image on a sheet, comprising:
a main body (1) including a metallic structural body (6);
a switch unit (71) that is supported by the main body (1), includes a pressed part (71a), and has an electrified state which switches between a state in which the pressed part (71a) is pressed and a state in which the pressed part (71a) is not pressed;
a press button (72) that is supported to be movable by a cover member (100) that closes the main body (1) or an opening of the main body (1) and moves from a reference position away from the pressed part (71a) to a pressure position to press the pressed part (71a) by being pressed; and
an electrically conductive, electrostatic conduction member (76) that is supported by the main body (1) and includes a contact part (76a) that comes into contact with a portion of the structural body (6) and a button proximity part (76b) that is arranged at a position closer to the press button (72) located at the reference position than the switch unit (71).

2. The image forming apparatus (10) according to claim 1, wherein
the main body (1) includes
a first opening (1a) to a portion on which a developing agent unit that houses a developing agent in the main body (1) is mounted, and
an interior member (1b) that includes a second opening (1d) to the pressed part (71a) and a portion of the switch unit (71) other than the pressed part (71a),
the cover member (100) is supported to be movable between a close position to cover a specific region in the main body (1), which includes the first opening (1a) and the interior member (1b), and an open position to open the specific region, and
the button proximity part (76b) is arranged at an edge of the second opening (1d) in the interior member (1b).

3. The image forming apparatus (10) according to claim 1 or 2, further comprising
an electrical unit (70) that includes the switch unit (71) and the electrostatic conduction member (76) and is attached to the main body (1), wherein
the structural body (6) includes a plurality of pipe members (60) joined,
the plurality of pipe members (60) each has an electrically conductive, tubular base portion and an electrically conductive plating portion that is formed on the surface of the base portion and is lower in electrical conductivity than the base portion,
the electrostatic conduction member (76) is an elastically deformable, metallic wire,
the contact part (76a) is a bent part that hits a surface of a specific pipe member (60), which is one of the plurality of pipe members (60), and
the bent part slides on the surface of the specific pipe member (60) when the electrical unit (70) is inserted at an attachment position in the main body (1) in a predetermined insertion direction.
